# EUROPEAN PATENT APPLICATION

(11) **EP 4 718 965 A1**
(43) Date of publication of application: **01.04.2026**
(21) Application number: 25205021.6
(22) Date of filing: 26.09.2025
(51) Int. Cl.: H05K 13/00

(54) **A CARRIER TAPE FOR ACCOMMODATING A PLURALITY OF SEMICONDUCTOR PACKAGES AND A METHOD OF FORMING ONE**

(30) Priority: 26.09.2024 NL 2038724
(71) Applicant: Nexperia B.V., 6534 AB Nijmegen (NL)
(72) Inventor: Yeung, Shun Tik, Hong Kong (HK)
(74) Representative: Pjanovic, Ilija

(57) **Abstract**

The present disclosure proposes a carrier tape for accommodating a plurality of dual in-line semiconductor packages. The carrier tape is formed of a flexible elongated tape having a first elongated tape side and a second elongated tape side oriented parallel to the first elongated tape side. One single elongated recess is provided between and extending along both elongated tape sides. Additionally, the carrier tape comprises a plurality of spacing elements present within the single elongated recess, which spacing elements orient - during use - the plurality of dual in-line semiconductor packages within the single elongated recess in a side-by-side manner, such that at least one lead terminal of a first semiconductor package interleaves with lead terminals of a neighboring semiconductor package.

## Description

### TECHNICAL FIELD

The present disclosure relates to a carrier tape and a method of forming one for accommodating a plurality of semiconductor packages in particular having an improved packaging capacity.

### BACKGROUND OF THE DISCLOSURE

Semiconductor package products are commonly packaged in a carrier tape which is closed off with a cover tape. The carrier tape is an embossed or shaped plastic intended for holding the semiconductor packages during transport to a customer or to a further processing facility. Together with the cover tape, it is assured that no physical or electrostatic damage can be done to the semiconductor packages during said transport.

Semiconductor package manufacturing typically utilizes reel-to-reel methods to achieve an optimized manufacturing process. With reel-to-reel methods, the process can be run continuously to achieve high volumes of the semiconductor packages. Therefore similarly, accommodating the finished semiconductor package into the carrier tape is also performed through reel-to-reel methods.

The carrier tape is provided with an index hole at a regular spacing corresponding with a slot for a semiconductor package. The amount of plastic of the carrier tape needed per semiconductor package is therefore of economic interest to guarantee a good price for the semiconductor package, but also of environmental interest, since the carrier tape, after arrival and unpacking, is simply scrapped.

Accordingly, it is a goal of the present disclosure to provide an improved carrier tape for packing a plurality of semiconductor packages, such that an increased packaging capacity can be achieved.

### SUMMARY OF THE DISCLOSURE

According to a first example of the disclosure, a carrier tape for accommodating a plurality of dual in-line semiconductor packages. The carrier tape is formed of a flexible elongated tape having a first elongated tape side and a second elongated tape side oriented parallel to the first elongated tape side, as well as one single elongated recess provided between and extending along both elongated tape sides. The single elongated recess is formed by a bottom surface and two adjacent surface sides, and the carrier tape comprises a plurality of spacing elements present within the single elongated recess, which spacing elements orient - during use - the plurality of dual in-line semiconductor packages within the single elongated recess in a side-by-side manner, such that at least one lead terminal of a first semiconductor package interleaves with lead terminals of a neighboring semiconductor package. In other words, one lead terminal of a first semiconductor package nests in an intermediate space present between two lead terminals of a neighboring semiconductor package.

A carrier tape according to this configuration has the advantage that side-by-side semiconductor packages can be accommodated into the carrier tape more space-efficiently, such that the semiconductor-package-to-semiconductor-package pitch size can be reduced. This has the ultimate result that the semiconductor package price will be cheaper and that less plastic is scrapped after use, thereby being commercially and environmentally more interesting than the prior art carrier tapes.

Furthermore, the spacing elements provided in the single elongated recess ensure that the semiconductor packages remain at their intended spot on the carrier tape. Specifically, since the semiconductor packages are interleaved, these spacing element by keeping the semiconductor packages at their intended spot guarantee that they will not collide with neighboring semiconductor packages.

In an example of the disclosure, the plurality of spacing elements are formed as pillar shaped projecting from a bottom surface of the single elongated recess, structured to engage with a side edge of a dual in-line semiconductor package.

In this example, the spacing elements' positions may be such that they can act as bumpers and translation stops for the semiconductor packages to limit their motion during transport. Being formed as a pillar structured to engage with a side of a semiconductor package is an efficient form to act as a motion-limiting element.

In another example of the disclosure, the plurality of spacing elements are formed as tabs projecting from one or both surface sides of the single elongated recess, structured to engage with a side edge of a dual in-line semiconductor package.

Alternative to or in addition to the spacing elements formed as pillars, another efficient form to limit the translation of the semiconductor packages may be the spacing element shaped as a tab projected from a side of the single elongated recess. Such a spacing element shape allows to act as a bumper or a translation-limiting element at different side edges of the semiconductor package.

For instance, the tab-shaped spacing elements may be engaging with the side edges of the semiconductor, whereon no lead terminals are provided. Alternatively, these spacing elements could be provided in between neighboring semiconductor packages, thereby actually engaging with side edge on which the lead terminals are provided. In the latter case, the tab-shaped spacing elements might even engage with the lead terminals of the semiconductor package.

In yet another example of the disclosure, the tabs are structured to orient the plurality of dual in-line semiconductor packages within the single elongated recess in a side-by-side yet staggered orientation seen in a direction perpendicular to a longitudinal direction of the single elongated recess.

Depending on the lead terminal layout of the semiconductor packages to-be accommodated, it might be needed to stagger neighboring semiconductor packages. For instance, if the positions of the lead terminals are evenly distributed over the length of the semiconductor package, staggering might not be necessary if one side of the semiconductor package has an even number of lead terminals and the other side an even number of lead terminals. However, staggering would definitely be needed in case of both sides have an odd or both sides have an even number of lead terminals.

Having the tabs-shaped spacing elements directing and orienting the semiconductor packages into this staggered arrangement may help during the accommodations of the semiconductor packages into the carrier tape, since they may expedite the accommodation process.

In a further example, the plurality of spacing elements orient the plurality of dual in-line semiconductor packages within the single elongated recess in a side-by-side yet 180° alternating position (sic. orientation).

As discussed in the previous example, staggering might be beneficial depending on the actual lead terminal layout of the semiconductor package. In a similar fashion rotation might be the most beneficial way of accommodating the semiconductor package into the carrier tape.

For instance, if the positions of the lead terminals are not evenly distributed over the length of the semiconductor package, but the number of lead terminals on either side might be the same, then it could be beneficial to accommodate the semiconductor packages in a side-by-side yet 180° alternating position.

The carrier tape, in yet another example, may also be provided with a series of sprocket holes extending alongside at least one of the elongated tape sides.

These sprocket holes can help to index the semiconductor packaging during both accommodating as well as packing out. For instance, each sprocket hole may correspond to one single semiconductor package, yet alternatively, one sprocket hole could correspond to a plurality of semiconductor packages, such as two, three, four, etc. Nevertheless, it is not limited that the sprocket holes should have integer numbers or that they correspond with the semiconductor packages at all. They might even simply be used to measure the length of the carrier tape independently of the semiconductor packages.

In a further example, the carrier tape is made from a polymeric material, such as polycarbonate (PC), polystyrene (PS), acrylonitrile butadiene styrene (ABS), Polyethylene terephthalate (PET), high impact polystyrene (HIPS), or the like.

These particular materials have different beneficial properties, which depend on their utility case. For instance, they might be chosen because of their rigidity, recyclability, anti-electrostatic properties, or the like.

In yet another example, the carrier tape comprises a removable cover foil at least sealing the single elongated recess and in a particular example thereof, the cover tape is provided with an adhesive layer and made from a polymeric material, such as polycarbonate (PC), polystyrene (PS), acrylonitrile butadiene styrene (ABS), Polyethylene terephthalate (PET), high impact polystyrene (HIPS), or the like.

Having a cover tape on top of the cover foil allows for containing and protecting the semiconductor packages against any outside influences, and also restricts the movement of the semiconductor packages. Additionally, the cover foil allows for automation in the reel-to-reel process, since the carrier tape can simply be sealed after accommodating the semiconductor packages. More in particular, the actual cover foil material may be chosen because of its beneficial advantages, such as anti-static properties and/or transparency.

In a second aspect, the disclosure pertains to a method of forming a carrier tape structured for accommodating a plurality of dual in-line semiconductor packages, such that the plurality of dual in-line semiconductor packages within a single elongated recess - during use - are accommodated in a side-by-side manner, such that at least one lead terminal of a first semiconductor package interleaves with lead terminals of a neighboring semiconductor package.

A carrier tape according to the disclosure may be formed in a stamping process, wherein a negative mold of the to be formed recess is stamped into a heated carrier tape. This way, the process of forming the carrier tape may be performed in a reel-to-reel process as well, such that the efficiency of forming can be guaranteed.

All in all, a carrier tape according to the disclosure allows to efficient accommodation of a plurality of semiconductor packages, such that less carrier tape material is needed per semiconductor package, thereby improving the cost-structure of the semiconductor package and aiding its environmental impact.

### BRIEF DESCRIPTION OF THE DRAWINGS

The disclosure will now be discussed with reference to the drawings, which show in:
Fig. 1 shows a top view of an example of a carrier tape known in the art;
Fig. 2 shows a top view of an example of a carrier tape according to the disclosure;
Fig. 3 shows a top view of another example of a carrier tape according to the disclosure;
Fig. 4 shows a cross-section of an example of a carrier tape according to the disclosure;
Fig. 5 shows a top view of another example of a carrier tape;
Fig. 6 shows yet another top view of another example of a carrier tape.

### DETAILED DESCRIPTION OF THE DISCLOSURE

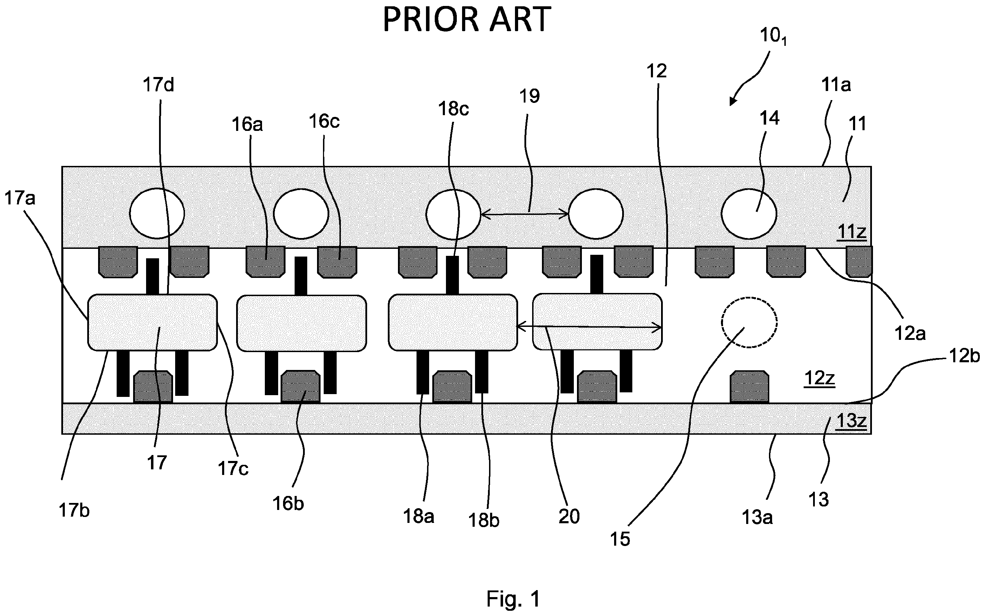

Figure 1 shows a top view of a carrier tape which is known in the art. The carrier tape 10₁ is an embossed or shaped plastic intended for accommodating and holding semiconductor packages 17 during transport to a customer or to a further processing facility.

The carrier tape 10₁ comprises an elongated tape first edge 11, which comprises an elongated tape first edge side 11a and an elongated tape first edge surface 11z which is positioned against a single elongated recess 12. The carrier tape 10₁ further comprises sprocket holes 14, which may be used to index the carrier tape 10₁ in relation to the semiconductor packages 17. However, this is not a prerequisite, the sprocket holes may also be utilized to measure the length of the carrier tape or could be used as a guide for the carrier tape in a reel-to-reel process. These sprocket holes 14 are positioned from each other at specific distances creating a sprocket hole 19, which is governed along the carrier tape 10₁.

The single elongated recess 12 comprises a first elongated recess side 12a and a second elongated recess side 12b, wherein the first elongated recess side 12a is extending from the elongated tape first edge 11 to the single elongated recess surface 12z and wherein the second elongated recess side 12b is extending from an elongated tape second edge 13 to the single elongated recess surface 12z. The elongated tape second edge 12 comprises an elongated tape second edge side 13b and an elongated tape second edge surface 13z. The single elongated recess is arranged for accommodating a plurality of dual in-line semiconductor packages 17, or any other suitable semiconductor package. The semiconductor packages 17 may be placed directly on top of a visual inspection opening 15 in the bottom surface of the single elongated recess, which may be used for visual inspection and/or handling of the placed semiconductor package, such as ejection of the package. In the prior art, tab-shaped spacing elements 16a-c are placed to accommodate the semiconductor package 17, wherein the lead terminals 18a-c of the semiconductor package 17 are directed towards the first and the second elongated recess sides 12a; 12b.

In this configuration the semiconductor packages 17 are oriented side by side, wherein the first dual in-line semiconductor package side 17a of a one semiconductor package 17 is facing the third dual in-line semiconductor package side 17c of another semiconductor package, and the first and second lead terminals 18a-18b are provided on the second dual in-line semiconductor package side 17b and the third lead terminal 18c is provided on the fourth dual in-line semiconductor package side 17d. This creates a semiconductor-package-to-semiconductor-package pitch size 20 ranging from the first dual in-line semiconductor package side 17a of one semiconductor package 17 to the same surface side 17a of another semiconductor package 17.

The problem of carrier tapes 10₁, as shown in Fig. 1, known in the art is that the amount of plastic/material of the carrier tape 10₁ needed per semiconductor package 17 is not optimized. Namely, the amount material per semiconductor package 17 is economically and environmentally burdening, leading to increased costs and bad impact on the environment after unpacking, as the carrier tape 10₁ is typically scrapped.

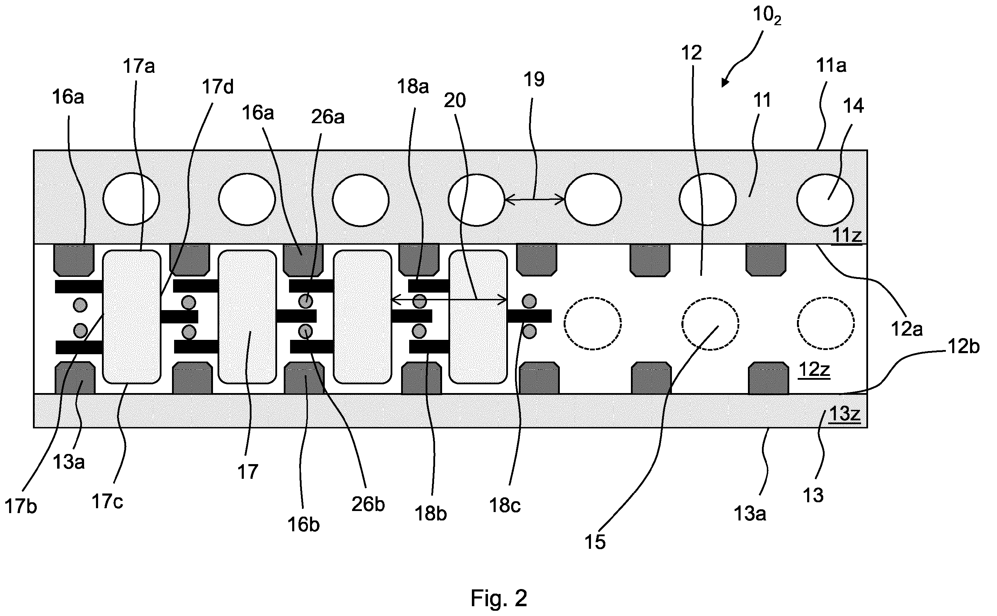

Therefore, the disclosure provides an improved carrier tape 10₂ for packing a plurality of semiconductor packages 17, as shown in a top view in Fig. 2, such that an improved packaging capacity can be achieved. A carrier tape according to this configuration has the advantage that side-by-side semiconductor packages can be accommodated into the carrier tape more space-efficiently, such that the semiconductor-package-to-semiconductor-package pitch size 20 can be reduced. The material used in the improved carrier tape is therefore reduced compared to the carrier tape known in the art, which makes it interesting both economically and environmentally.

In the improved carrier tape 10₂, the semiconductor packages 17 are placed with the lead terminals 18a-c of the semiconductor package 17 oriented along the recess 12 and thereby along the carrier tape 10₂. In other words, the second dual in-line semiconductor package side 17a is provided with a first and a second lead terminal 18a; 18b. The first and the third dual in-line semiconductor package sides 17a; 17c are facing the first and the second elongated recess sides 12a; 12b, respectively. The fourth dual in-line semiconductor package side 17d is provided with the third lead terminal 18c, and the semiconductor packages 17 are positioned such that fourth dual in-line semiconductor package side 17d of one semiconductor package is facing the first dual in-line semiconductor package side 17a of another semiconductor package 17, wherein the third lead terminal 18c of the one semiconductor package 17 is positioned in between the first and the second lead terminals 18a; 18b of the another semiconductor package 17.

To inhibit the movement of the semiconductor packages 17 in the carrier tape 10₂, an elongated tape first edge 11 and a and an elongated tape second edge 13 are provided with spacing elements. Being in contact with the first and second elongated recess edge 12a; 12b, the spacing elements are tab-shaped spacing elements 16a; 16b. To inhibit the movement of the semiconductor package 17 at the lead terminals 18a-c, the spacing elements are pillar-shaped spacing elements 26a; 26b. A combination of both spacing elements 16; 26 may be used depending on the actual shape of the semiconductor package 17.

Whereas the tab-shaped spacing elements 16 ensure separation of the semiconductor package 17 body, the pillar-shaped spacing elements may ensure the separation of interleaved lead terminals 18a; 18b of one semiconductor package 17 and lead terminal 18c of another semiconductor package 17, such that the lead terminals do not touch and damage each other. They may alternatively function similarly as the tab-shaped spacing elements 16, keeping the semiconductor package 17 at its body in place.

The configuration of the carrier tape 10₂ according to the disclosure with the use of spacing elements 16; 26 results in a reduction in package-to-package pitch size 20, which in turn results in a sprocket hole pitch size 19 reduction. Due to the interleaving of the lead terminals, a greater density of placed semiconductor packages is achieved, thereby utilizing carrier tape space more effectively and thus reducing the needed material. This therefore makes the improved carrier tape 10₂ interesting, both economically and environmentally.

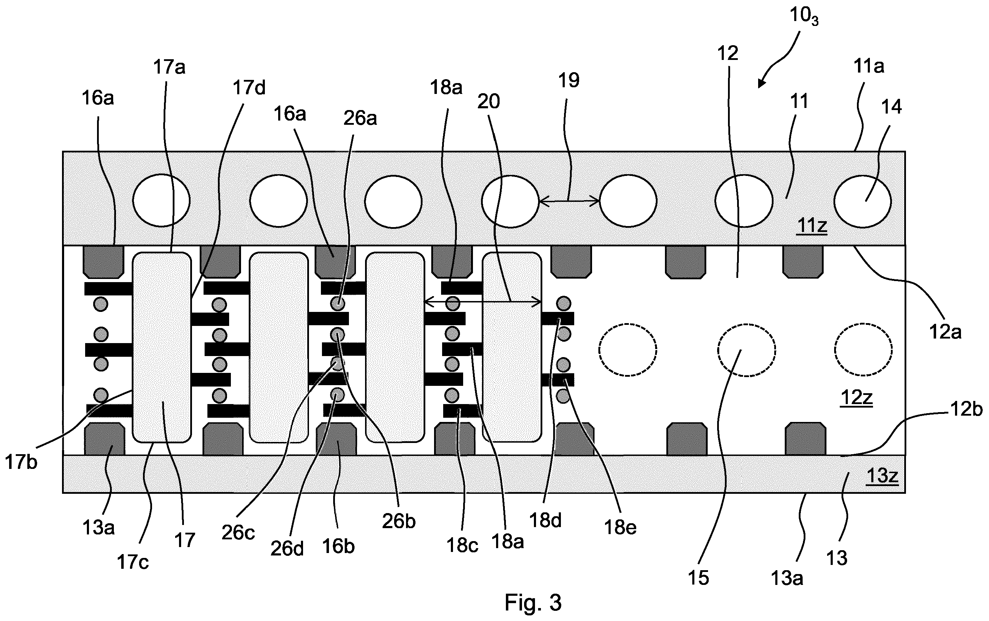

In Fig. 3 another carrier tape 10₃ according to the disclosure is shown. This carrier tape is similar to the carrier tape in Fig. 2 but comprises four pillar-shaped spacing elements 26a-d to space apart the lead terminals 18 of the semiconductor package 17. Here, it is shown that the carrier tape 10₃ according to the disclosure can also be utilized for semiconductor packages 17 comprising five lead terminals 18a-18e. To do so, four pillar-shaped spacing elements 26a-d are positioned in between interleaved lead terminals 18 of neighbouring semiconductor packages 17. In a similar fashion, semiconductor packages 17 having more lead terminals 18 can also be contained in the carrier tape 10 according to the disclosure.

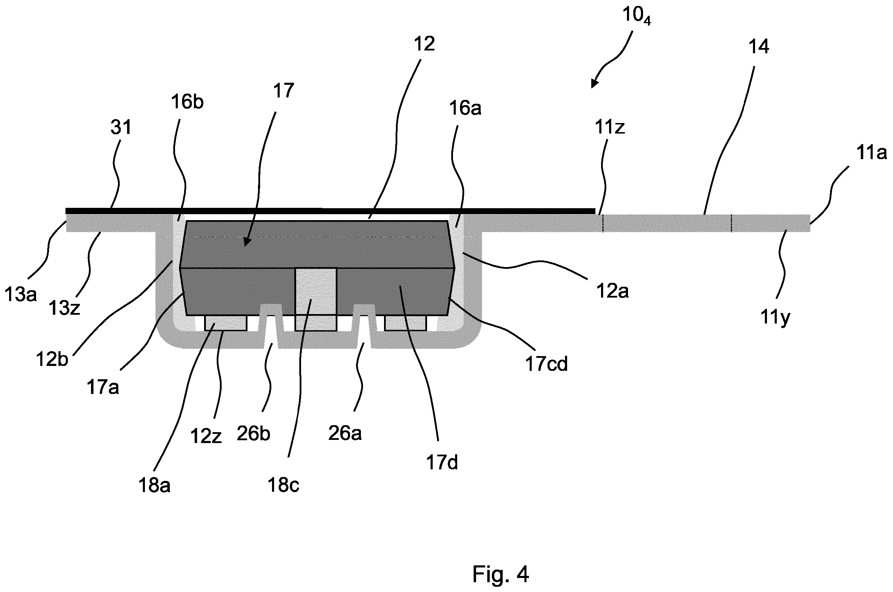

Fig. 4 shows a side view of another example carrier tape 10₄ according to the disclosure, wherein a semiconductor package 17 is accommodates and closed-off to influences of the outside by a carrier tape cover 31. Having a cover tape on top of the cover foil allows for containing and protecting the semiconductor packages against any outside influences, and also restricts the movement of the semiconductor packages. Additionally, the cover foil allows for automation in the reel-to-reel process, since the carrier tape can simply be sealed after accommodation of the semiconductor packages. More in particular, the actual cover foil material may be chosen because of its beneficial advantages, such as anti-static properties and or transparency

The carrier tape further comprises all elements identified in Fig. 2, such as the first and second elongated tape edges 11; 13, and the single elongated recess 12 positioned in between. The first and second elongated recess side edges 12a, 12b are shown to extend from the first and second elongated tape edges 11, 13, respectively, to the elongated recess surface 12z.

To limit the range of motion of the accommodated semiconductor package 17. The first and second elongated recess sides edges 12a; 12b are provides with tab-shaped spacing elements 16a; 16b, and to limit the range of motion of the semiconductor package 17 even further the elongated recess surface 12z is provided with pillar shaped spacing elements 26a; 26b, such that the lead terminals 18a-c cannot touch any other lead terminals 18a-c of another semiconductor package 17.

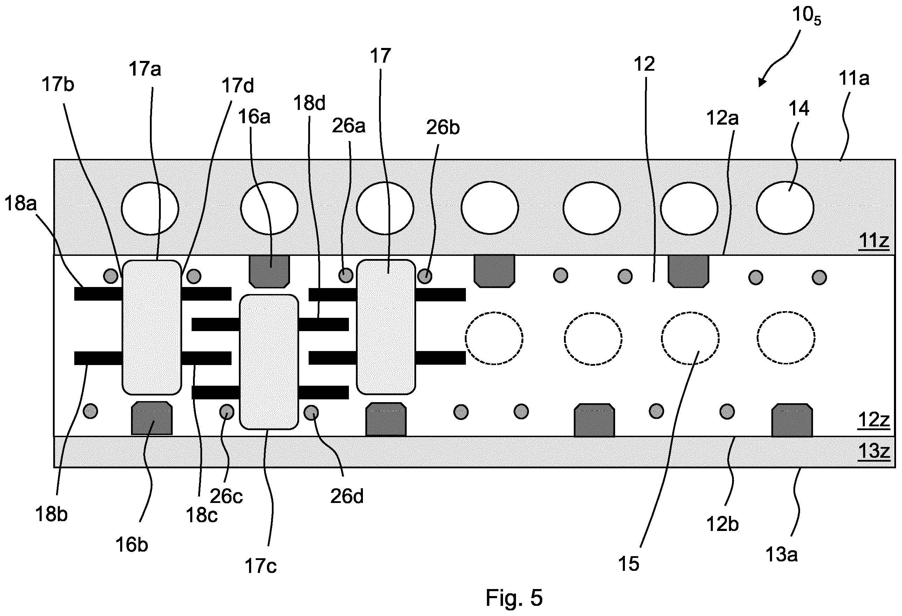

In Fig. 5, another example of an improved carrier tape 10₅ according to the disclosure is shown. Herein the semiconductor packages 17 are held in place by a tab-shaped spacing element 16a and the second elongated recess side 12b, or alternatively by a tab-shaped spacing element 16b and the first elongated recess side 12a.

To further confine the movement of the semiconductor package 17 two pillar-shaped spacing elements 26a; 26b or 26c; 26d, respectively, are positioned at one end of the semiconductor package 17 adjacent to the second and the fourth dual in-line semiconductor package side 17b; 17d. The tab-shaped spacing elements 16a; 16b ensure no significant movement is possible toward the first or second elongated recess side 12a; 12b and the two pillar-shaped spacing elements 26a; 26b or 26c; 26d ensure significant movement in the direction along the recess 12 is prevented. The tab-shaped spacing elements 16a; 16b are placed in an alternating pattern. This means that the semiconductor packages may be placed in a staggered or zig-zag-like pattern, ensuring that the lead terminals of the semiconductor package are interleaved and do not touch.

The pillar-shaped spacing elements 26a; 26b or 26c; 26d are accordingly placed in an alternating pattern on the opposite recess edge 12a; 12b of where the tab-shaped spacing element 16a; 16b is provided.

The example of the carrier tape 10₅ possesses the advantages of the improved carrier tape according to the disclosure of needing less carrier tape material per semiconductor package 17, while allowing for accommodating even symmetric semiconductor packages, whereas the example of the carrier tape 10₂ of Fig. 2 is beneficial for asymmetric semiconductor packages 17.

Symmetric, here, refers to the symmetry of the semiconductor package with respect to an interface running through the middle of the semiconductor package perpendicular to the direction of the lead terminals 18. In order to be symmetric, these semiconductor packages comprise the same number of lead terminals at both sides of this symmetry interface. Note that this number of lead terminals 18 may be any natural number greater than 1. Furthermore, the lead terminals in semiconductor packages 17 are typically evenly spaced along the side of the semiconductor package 17b; 17d, but there are not limited thereto. A semiconductor package 17 having unevenly space lead terminals 18 could still be accommodated in the carrier tape 10₂, 10₃, or 10₄.

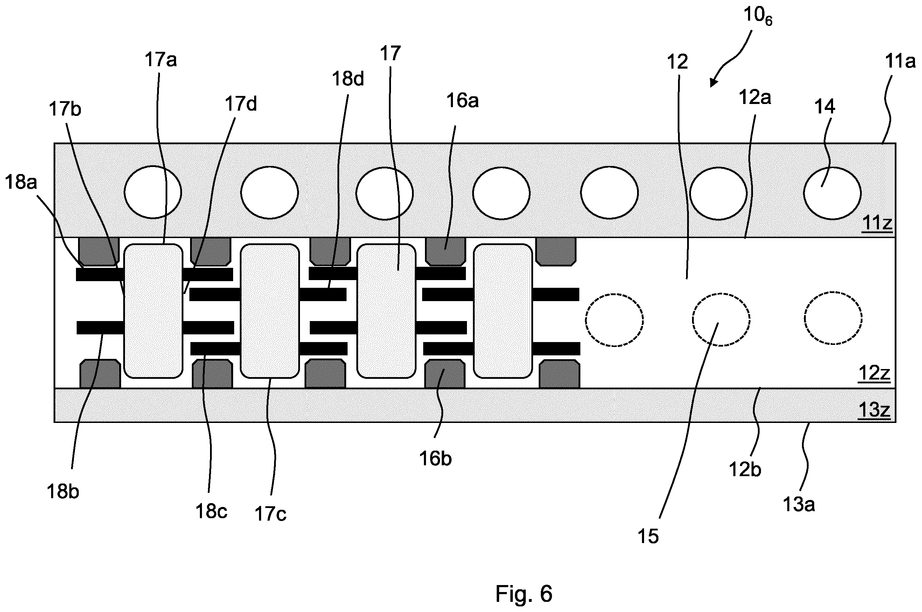

For the remainder of cases, the disclosure further provides yet another example of a carrier tape 10₆, as shown in Fig. 6. Here, an asymmetric semiconductor packages 17 comprising the same number of lead terminals 18 on either side of the semiconductor 17b; 17d is accommodated in the carrier tape 10₆.

To do so, the semiconductor packages 17 are placed in an alternating pattern, wherein neighbouring semiconductor packages are placed side-by-side yet 180° alternating orientation with respect to each other. This ensures that the lead terminals of the semiconductor packages are interleaved and not touching each other.

In the example of Fig. 6, this time only tab-shaped spacing elements 16a; 16b are utilized in order to position the semiconductor packages 17 in the elongated recess 12 of the carrier tape 10₅. It should be noted that, alternatively, only pillar-shaped spacing elements 26a; 26b could have been used as well. These two type of spacing elements are mostly interchangeable and depend on the exact requirements and constraints of the carrier tape.

The example shown in Fig. 6 can be alternatively used to provide the accommodation of further different semiconductor packages, indicating the flexible nature of the example according to the disclosure. Mainly due to interleaving of the terminal leads 18 of the semiconductor packages 17, improved accommodation efficiency can be achieved.

Alignment elements may be shape conformal to the semiconductor package 17, lead terminals 18 or parts thereof. Therefore, any tab-shaped or pillar-shaped alignment element may comprise an alternative shape other than square, circular, rounded square, rectangular, triangular, etc, as long as its functionality of inhibiting the movement of the semiconductor package 17 is preserved. Further examples of pillar-shaped elements may be star-shaped, triangular, square, or any other possible shape. Furthermore, tabs-shaped elements may alternatively be replaced by a plurality of pillars or vice-versa, which in combination or on their own comprise the same functionality.

Lastly, the material of all the examples of carrier tapes 10₂, 10₃, 10₄, 10₅, and 10₆, are typically made of a polymeric material, such as polycarbonate (PC), polystyrene (PS), acrylonitrile butadiene styrene (ABS), Polyethylene terephthalate (PET), high impact polystyrene (HIPS), or the like, thereby resulting in a lower cost and allowing for a more environmentally friendly design. The particular material may have different beneficial properties, which depend on their utility case. For instance, a material may be chosen because of their rigidity, recyclability, anti-electrostatic properties, or the like.

All in all, a carrier tape according to the disclosure allows to efficient accommodation of a plurality of semiconductor packages, such that less carrier tape material is needed per semiconductor package, thereby improving the cost-structure of the semiconductor package and aiding its environmental impact.

### LIST OF REFERENCE NUMERALS USED

- 10: carrier tape
- 11: elongated tape first edge
- 11a: elongated tape first edge side
- 11z: elongated tape first edge surface
- 12: single elongated recess
- 12a: first elongated recess side
- 12b: second elongated recess side
- 12z: surface of single elongated recess
- 13: elongated tape second edge
- 13a: elongated tape second edge side
- 13z: elongated tape second edge surface
- 14: sprocket hole
- 15: visual inspection opening in bottom surface of single elongated recess
- 16a-c: tab shaped spacing elements
- 17: dual in-line semiconductor package
- 17a-d: first - fourth dual in-line semiconductor package side
- 18a-e: first - fourth lead terminals extending from the second and fourth dual in-line semiconductor package sides
- 19: sprocket hole pitch
- 20: semiconductor-package-to-semiconductor-package pitch size
- 26a-d: pillar shaped spacing elements
- 31: carrier tape cover

## Claims

1. A carrier tape for accommodating a plurality of dual in-line semiconductor packages, the carrier tape being formed of a flexible elongated tape having a first elongated tape side and a second elongated tape side oriented parallel to the first elongated tape side, as well as one single elongated recess provided between and extending along both elongated tape sides, wherein the carrier tape comprises a plurality of spacing elements present within the single elongated recess, which spacing elements orient - during use - the plurality of dual in-line semiconductor packages within the single elongated recess in a side-by-side manner, such that at least one lead terminal of a first semiconductor package interleaves with lead terminals of a neighboring semiconductor package.

2. The carrier tape according to claim 1, wherein the plurality of spacing elements is formed as pillar shaped projecting from a bottom surface of the single elongated recess.

3. The carrier tape according to any one or more of the preceding claims, wherein the plurality of spacing elements is formed as tabs projecting from one or both surface sides of the single elongated recess.

4. The carrier tape according to claim 3, wherein the tabs are structured to orient the plurality of dual in-line semiconductor packages within the single elongated recess in a side-by-side yet staggered orientation seen in a direction perpendicular to a longitudinal direction of the single elongated recess.

5. The carrier tape according to any one or more of the preceding claims, wherein the plurality of spacing elements orients the plurality of dual in-line semiconductor packages within the single elongated recess in a side-by-side yet 180° alternating position.

6. The carrier tape according to any one or more of the preceding claims, wherein the carrier tape is provided with a series of sprocket holes extending alongside at least one of the elongated tape sides.

7. The carrier tape according to any one or more of the preceding claims, wherein the carrier tape is made of a polymeric material, such as polycarbonate (PC), polystyrene (PS), acrylonitrile butadiene styrene (ABS), Polyethylene terephthalate (PET), high impact polystyrene (HIPS), or the like.

8. The carrier tape according to any one or more of the preceding claims, wherein the carrier tape comprises a removable cover foil at least sealing the single elongated recess.

9. The carrier tape according to claim 8, wherein the cover tape is provided with an adhesive layer and made of a polymeric material, such as polycarbonate (PC), polystyrene (PS), acrylonitrile butadiene styrene (ABS), Polyethylene terephthalate (PET), high impact polystyrene (HIPS), or the like.

10. A method of forming a carrier tape structured for accommodating a plurality of dual in-line semiconductor packages according to any of the preceding claims, such that the plurality of dual in-line semiconductor packages within a single elongated recess - during use - are accommodated in a side-by-side manner, such that at least one lead terminal of a first semiconductor package interleaves with lead terminals of a neighboring semiconductor package.
